# EUROPÄISCHE PATENTSCHRIFT

(11) **EP 2 368 837 B1**
(45) Veröffentlichungstag und Bekanntmachung des Hinweises auf die Patenterteilung: **05.08.2015**
(21) Anmeldenummer: 10157258.4
(22) Anmeldetag: 22.03.2010
(51) Int. Cl.: B81B 3/00

(54) **Leiterplattensensor und Verfahren zur Herstellung desselben**
Circuit board sensor and method for manufacturing the same
Capteur sur circuit imprimé et son procédé de fabrication

(43) Veröffentlichungstag der Anmeldung: 28.09.2011
(73) Patentinhaber: Waser, Werner, 8472 Seuzach (CH); Brinkhaus, Bernhard, 8955 Oetwil an der Limmat (CH)
(72) Erfinder: Waser, Werner, 8472 Seuzach (CH); Brinkhaus, Bernhard, 8955 Oetwil an der Limmat (CH)
(74) Vertreter: Graf, Werner

(56) Entgegenhaltungen:
- WO-A2-2007/079072

## Beschreibung

Die vorliegende Erfindung betrifft einen Leiterplattensensor gemäss dem Oberbegriff von Anspruch 1. Die vorliegende Erfindung betrifft weiter ein Verfahren zum Herstellen eines Leiterplattensensors gemäss dem Oberbegriff von Anspruch 13.

### Stand der Technik

Die vorliegende Erfindung bezieht sich auf das Gebiet der elektronischen Messung von physikalischen Grössen, wie z.B. Druck, Kraft oder Beschleunigung.

Das Gebiet der Sensorik ist sehr weit reichend. Heute können Sensoren für die unterschiedlichsten Messaufgaben gebaut werden. Das bezieht sich einerseits auf die durch den Sensor zu messende Grösse, andererseits auf die durch den Sensor zu erfüllenden Bedingungen. Die zu messenden Grössen sind meist physikalische oder chemische Grössen. Die zu erfüllenden Bedingungen wechseln je nach Einsatzgebiet des Sensors und können zu völlig unterschiedlichen Bauarten für einen einzigen Sensor führen.

Der Zweck eines Sensors ist die Wandlung von physikalischen oder chemischen Grössen in ein elektrisches Signal. Dieses wiederum kann von elektronischen, elektrischen und / oder mechanischen Systemen erfasst und verarbeitet werden. Das vom Sensor erzeugte, elektrische Signal kann dabei in unterschiedlichen Formen vorliegen.

Zur Umwandlung von physikalischen Grössen in elektrische Grössen werden heute unterschiedliche Techniken und Technologien eingesetzt. Meistens ist der Sensor ein Element und oft ist auch eine dem Sensor nachgeschaltete Signalverarbeitung erforderlich, welche einerseits dazu dient, unerwünschte Nebeneinflüsse zu reduzieren und andererseits das Signal auf eine standardisierte Basis zu stellen. Ist dem Sensor eine Signalverarbeitungsschaltung nachgeschaltet, so wird heute oft von einem sogenannten Transmitter gesprochen.

Dokument WO 2007/079072 A2 beschreibt einen Drucksensor bestehend aus Glasplatten.

Obwohl eine Vielzahl von Sensoren bekannt ist besteht immer noch der Bedarf nach kostengünstigen, zuverlässigen und robusten Sensoren.

### Darstellung der Erfindung

Aufgabe der Erfindung ist es einen wirtschaftlich vorteilhafteren Sensor zu bilden. Der Sensor sollte insbesondere sehr kostengünstig herstellbar sein und vorzugsweise auch sehr robust und zuverlässig sein.

Diese Aufgabe wird insbesondere gelöst mit einem Leiterplattensensor zum Messen von physikalischen Grössen, umfassend eine Basisplatte sowie eine zweite Platte welche beide aus Glas bestehen, wobei zumindest die zweite Platte derart ausgestaltet ist, dass diese elastisch verformbar ist, wobei die Basisplatte sowie die zweite Platte je eine erste und eine zweite Seite aufweisen, wobei die zweite Seite der Basisplatte sowie die erste Seite der zweiten Platte gegenüberliegend angeordnet sind und wobei zwischen der Basisplatte und der zweiten Platte ein Abstandelement angeordnet ist, welches die Basisplatte sowie die zweite Platte in einer gegenseitigen Distanz hält, wobei die Basisplatte und die zweite Platte insbesondere gegenseitig parallel verlaufen, wobei die zweite Seite der Basisplatte eine erste metallische oder polymerische Oberfläche und die erste Seite der zweiten Platte eine zweite metallische oder polymerische Oberfläche aufweist, und wobei die erste und zweite metallische oder polymerische Oberfläche zumindest teilweise gegenüberliegend angeordnet sind, und wobei auf der ersten Seite der Basisplatte Leiterbahnen aufgebracht sind, und wobei die Basisplatte zumindest eine erste und eine zweite Durchkontaktierung aufweist, welche derart angeordnet sind, dass die erste Durchkontaktierung die Leiterbahn elektrisch leitend mit der ersten metallischen oder polymerischen Oberfläche verbindet, und dass die zweite Durchkontaktierung die Leiterbahn elektrisch leitend mit der zweiten metallischen oder polymerischen Oberfläche verbindet.

Die Unteransprüche 2 bis 12 betreffend weitere vorteilhaft ausgestaltete Leiterplattensensoren.

Die Aufgabe wird weiter gelöst mit einem Verfahren zum Herstellen eines Leiterplattensensors zum Messen von physikalischen Grössen, indem eine Basisplatte aus Glas auf der ersten Seite mit Leiterbahnen versehen wird und auf der zweiten Seite zumindest mit einer ersten metallischen oder polymerischen Oberfläche versehen wird, und wobei die erste metallische oder polymerische Oberfläche über zumindest eine Durchkontaktierung zumindest mit einer Leiterbahn verbunden ist, und wobei eine zweite Platte aus Glas auf der ersten Seite zumindest mit einer zweiten metallischen oder polymerischen Oberfläche versehen wird, und wobei die Basisplatte sowie die zweite Platte derart mit Hilfe von Abstandelementen und/oder Leiterbahnen miteinander verbunden werden, dass die erste metallische oder polymerische Oberfläche der Basisplatte sowie die zweite metallische oder polymerische Oberfläche der zweiten Platte gegenseitig insbesondere parallel und gegenseitig beabstandet verlaufen, wobei die Basisplatte sowie die zweite Platte deckungsgleich ausgestaltet sind.

Die Unteransprüche 14 bis 15 betreffend weitere vorteilhafte Verfahrensschritte.

Der erfindungsgemässe Leiterplattensensor sowie das erfindungsgemässe Verfahren weisen den Vorteil auf, dass die Sensoren direkt unter Zuhilfenahme der Fertigungsprozesse für Leiterplatten hergestellt werden können und so, als Teil der Leiterplatte, in Standardfertigungsprozessen hergestellt werden können. Die erlaubt die Sensoren sehr kostengünstig und sehr zuverlässig herzustellen.

Ein weiterer Vorteil ist darin zu sehen, dass durch die Integration von verschiedenen Technologien und Eigenschaften von Messwandlern unter anderem die Herstellungskosten für die Sensoren und die Auswerteelektronik sehr kostengünstig sind. Es wurde erkannt, dass die heute bestehenden Leiterplattenfertigungstechniken eine Integration sowie einen Schichtaufbau von ganzen Sensoren erlauben, wobei diese Herstellprozesse sehr gut reproduzierbar sind und zur Herstellung einer Gross-Serienproduktion geeignet sind. Somit ist es möglich die Sensoren in sehr grosser Stückzahl und zudem sehr kostengünstig herzustellen. So ist es beispielsweise möglich 300 bis 1000 Sensoren in einem ersten Verfahrensschritt gleichzeitig auf derselben Basisplatte zu fertigen, um danach dies Basisplatte derart zu trennen, dass die Sensoren einzeln vorliegen.

Beim erfindungsgemässen Verfahren werden die Sensoren sowie die Leiterplatten in Schichtaufbau hergestellt. Ein Vorteil des erfindungsgemässen Sensors beziehungsweise des erfindungsgemässen Herstellungsverfahrens ist darin zu sehen, dass das Substrat, und/oder der Schichtaufbau, und/oder die Materialzusammensetzung und/oder die Geometrie der Leiterplatte sehr einfach, kostengünstig, und insbesondere auch in einer Vielzahl von Ausführungsformen variiert werden kann, und dass es möglich ist auch unterschiedlichste Bauformen von Sensoren kostengünstig und in grosser Stückzahl herzustellen.

Der erfindungsgemässe Sensor kann zum Messen einer Vielzahl physikalischer Grössen, insbesondere von Druck, Kraft oder Beschleunigung ausgestaltet sein. Der erfindungsgemässe Sensor kann in einer vorteilhaften Ausgestaltung zudem derart ergänzt werden, dass zusätzliche Messgrössen erfassbar sind, und beispielsweise ein Messen von chemischen Grössen möglich ist. Beim erfindungsgemässen Leiterplattensensor werden vorzugsweise die Sensoren, und deren Auswerteelektronik auf der Leiterplatte integriert. Dabei können das Substrat, der Schichtaufbau, die Materialzusammensetzung, die Geometrie der Leiterplatte sowie die Anordnung der elektrisch leitenden Bahnen auf unterschiedlichste Art gewählt sein, unter anderem auch abhängig von den zu wandelnden physikalischen oder chemischen Grössen. Nebst den physikalischen Grössen ist es zusätzlich möglich auch eine Vielzahl chemischer Grössen zu messen.

Der erfindungsgemässe Aufbau weist den Vorteil auf, dass Sensor-, Gehäuse- und Leiterplattentechnologien quasi in ein einziges Bauteil oder eine einheitliche Baugruppe integriert sind, was eine zuverlässige und kostengünstige Fertigung ermöglicht. Zudem bewirkt diese Anordnung eine Reduzierung von störenden Einflüssen weshalb eine zuverlässige Messwerterfassung möglich ist. Die Integration führt zudem zu sehr kleinen Sensoren. Somit ist es auch möglich einen Sensor und insbesondere auch eine Mehrzahl von Sensoren wie Multisensorstrukturen mit umfangreicher Auswerteelektronik auf einer einzigen Leiterplattenstruktur zu erzeugen. Hinzu kommt, dass durch geeignete Wahl der Geometrie der Leiterplattenstrukturen, die Form des Sensors vorteilhaft ausgestaltet werden kann, sodass diese eine für die jeweilige Applikation besonders vorteilhafte Form aufweisen kann, sodass der Sensor angepasst an die jeweilige Applikation sehr einfach und zweckmässig ausgestaltet werden kann.

### Kurze Beschreibung der Zeichnungen

Die zur Erläuterung der Ausführungsbeispiele verwendeten Zeichnungen zeigen:
- Fig. 1: einen Längsschnitt durch ein erstes Ausführungsbeispiel eines Leiterplattensensors;
- Fig. 2: einen Längsschnitt durch ein zweites Ausführungsbeispiel eines Leiterplattensensors;
- Fig. 3: eine Draufsicht auf eine Mehrzahl noch nicht getrennter Sensoren.

Grundsätzlich sind in den Zeichnungen gleiche Teile mit gleichen Bezugszeichen versehen.

### Wege zur Ausführung der Erfindung

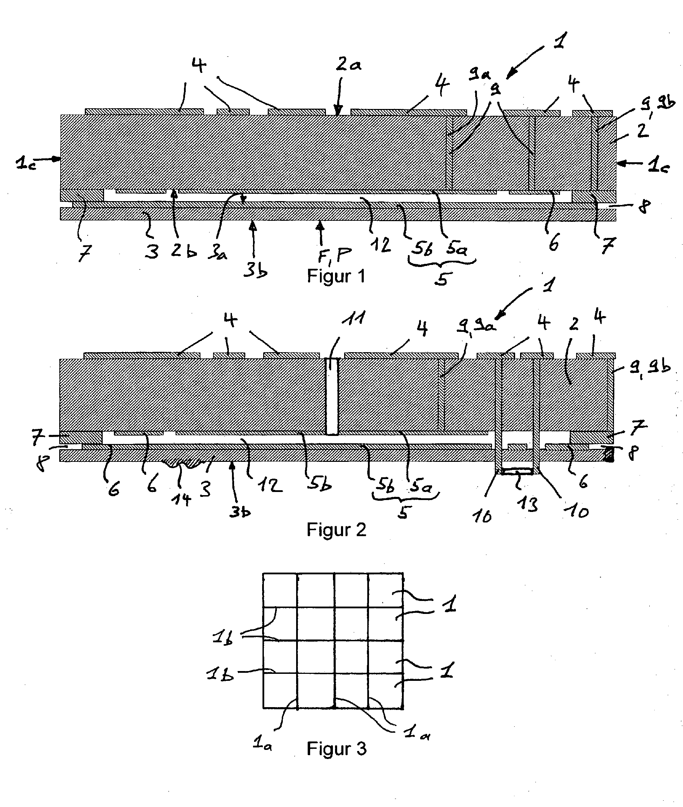

Figur 1 zeigt einen Längsschnitt durch einen Leiterplattensensor 1 zum Messen von physikalischen Grössen. Der Leiterplattensensor 1 umfasst eine Basisplatte 2 sowie eine zweite Platte 3 welche beide aus einem Glas bestehen. Zumindest die zweite Platte 3 ist derart ausgestaltet, dass diese elastisch verformbar ist. Die Basisplatte 2 sowie die zweite Platte 3 weisen je eine erste und eine zweite Seite 2a,2b,3a,3b auf, wobei die zweite Seite 2b der Basisplatte 2 sowie die erste Seite 3a der zweiten Platte 3 gegenüberliegend angeordnet sind und wobei zwischen der Basisplatte 2 und der zweiten Platte 3 ein Abstandelement 7 angeordnet ist, welches die Basisplatte 2 sowie die zweite Platte 3 gegenseitig beabstandet hält, wobei die Basisplatte 2 und die zweite Platte 3 vorzugsweise gegenseitig parallel verlaufen. Die zweite Seite 2b der Basisplatte 2 weist eine erste metallische oder polymerische Oberfläche 5a auf, und die erste Seite 3a der zweiten Platte 3 weist eine zweite metallische oder polymerische Oberfläche 5b auf, und wobei die erste und zweite metallische oder polymerische Oberfläche 5a, 5b zumindest teilweise gegenüberliegend angeordnet sind. Die beiden metallischen oder polymerischen Oberflächen 5a,5b sind elektrisch leitend und können beispielsweise einen Kondensator 5 ausbilden, dessen Kapazität sich ändert auf Grund der auf die zweite Platte 3 einwirkenden Kraft F beziehungsweise des auf die zweite Platte 3 einwirkenden Drucks P, was eine gegenseitige Verschiebung der Oberflächen 5a,5b und somit eine Veränderung der Kapazität zur Folge hat. Die Oberflächen 5a,5b könnten beispielsweise auch als Spulen beziehungsweise als Induktivitäten ausgestaltet sein, deren Interaktion sich auf Grund einer Biegung der zweiten Platte 3 und/ oder der Basisplatte 2 verändert. In einer vorteilhaften Ausgestaltung umfasst der Leiterplattensensor 1 zudem einen Referenzsensor, welcher im dargestellten Ausführungsbeispiel gemäss Figur 1 durch die Leiterbahn 6 und ein Teil der Oberfläche 5b ausgebildet wird. Die Leiterbahn 6 ist über eine Durchkontaktierung 9 mit einer Leiterbahn 4 verbunden. Die Durchkontaktierung wird beispielsweise durch Bohren erzeugt. Der in Figur 1 dargestellte Leiterplattensensor 1 könnte auch eine Mehrzahl von kapazitiven und/oder induktiven Sensoren aufweisen, welche vorzugsweise an der zweiten Seite 2b der Basisplatte 2 und an der ersten Seite 3a der zweiten Platte 3 angeordnet sind.

Auf der ersten Seite der Basisplatte 2 sind Leiterbahnen 4 aufgebracht, wobei die Basisplatte 2 zumindest eine erste und eine zweite Durchkontaktierung 9 aufweist, welche derart angeordnet sind, dass die erste Durchkontaktierung 9a die Leiterbahn 4 elektrisch leitend mit der ersten metallischen oder polymerische Oberfläche 5a verbindet, und dass die zweite Durchkontaktierung 9b die Leiterbahn 4 elektrisch leitend mit der zweiten metallischen oder polymerischen Oberfläche 5b verbindet. Die Leiterbahnen 4 sind vorzugsweise derart verlaufend an der ersten Seite 2a angeordnet, dass elektronische Bauteile wie elektronische Schaltungen mit diesen verbunden werden können.

In einer bevorzugten Ausgestaltung verlaufen die
Durchkontaktierungen wie in Figur 1 dargestellt durch das Glas der Basisplatte 2, wobei die Durchkontaktierung 9 vorzugsweise wie dargestellt bündig mit der ersten und zweiten Seite 2a,2b der Basisplatte 2 ist. Vorzugsweise wird im Glas zuerst eine Bohrung vorgenommen, welche danach vorzugsweise mit Metall gefüllt wird oder in welche ein Metall eingeführt wird, um derart eine Durchkontaktierung 9 zu erzeugen. Die Durchkontaktierung 9 kann jedoch auch, wie in Figur 2 dargestellt, entlang der Oberfläche des Glases der Basisplatte 2 verlaufen.

Das Abstandelement 7 kann als eine Leiterbahn 6 ausgestaltet sein.

In einer vorteilhaften Ausgestaltung ist das Abstandelement 7 und /oder die Leiterbahn 6 derart angeordnet sind, dass sich zwischen der Basisplatte 2 und der zweiten Platte 3 an der Aussenkante 1c ein Spalt 8 ausbildet. Dieser Spalt 8 weist unter anderem den Vorteil auf, dass die zweite Platte 3 einfacher biegbar ist.

In einer vorteilhaften Ausgestaltung ist das Abstandelement 7 und/oder die Leiterbahn 6 derart angeordnet, dass die Basisplatte 2 sowie die zweite Platte 3 derart umschlossen sind, dass zwischen der Basisplatte 2 und der zweiten Platte 3 ein umschlossener Innenraum 12 gebildet ist.

Figur 2 zeigt einen Längsschnitt durch ein zweites Ausführungsbeispiel eines Leiterplattensensors 1 zum Messen von physikalischen Grössen. Die Basisplatte 2 weist einen fluiddurchlässigen Durchgang 11 auf, welcher von der ersten Seite 2a bis zum Innenraum 12 verläuft und somit eine Fluid durchlässige Verbindung zwischen dem Innenraum 12 und dem Aussenraum bildet.

Der Leiterplattensensor 1 kann zudem noch zusätzliche Sensoren umfassen. Wie in Figur 2 dargestellt kann der Leiterplattensensor 1 zumindest einen zweiten Sensor 13 umfassen, der beispielsweise an oder oberhalb der zweiten Seite 3b der zweiten Platte 3 angeordnet ist, wobei dieser Sensor 13 über elektrische Leiter 10 Signal leitend mit Leiterbahnen 4 verbunden ist, welche an der ersten Seite 2a der Basisplatte 2 angeordnet sind. Der Sensor 13 könnte beispielsweise als chemischer Sensor ausgestaltet sein und Beispiel aus Kohle bestehen, welche die Leitfähigkeit in Abhängigkeit der CO₂-Konzentration verändert, sodass die CO₂-Konzentration gemessen werden kann.

Der erfindungsgemässe Leiterplattensensor 1 kann in einer Vielzahl von Möglichkeiten ausgestaltet sein und, falls erforderlich, auch eine Vielzahl von Sensoren umfassen. Je nach erforderlicher Auswertelektronik können auf der Oberfläche beziehungsweise oberhalb oder unterhalb der Basisplatte 2 eine oder mehrere Isolationsschichten und/oder Leiterbahnenebenen 4 aufgebracht werden um die elektrischen Verbindungen zu den elektrischen Bauteilen zu ermöglichen. Die erforderlichen Verbindungen zu den Sensoren werden vorzugsweise mit Durchkontaktierungen 9 erzeugt, wobei die Durchkontaktierungen 9 vorzugsweise durch das Glas hindurch verlaufen.

Fig. 1 zeigt schematisch ein Ausführungsbeispiel eines Leiterplattensensors 1 zum Erfassen von physikalischen und chemischen Grössen. Der Leiterplattensensor 1 weist eine runde oder mehreckige, insbesondere eine viereckige, plane Geometrie auf. Es können sowohl auf der Oberseite 2a als auch auf der Unterseite 2b der Basisplatte 2 chemische oder physikalische Sensorelemente angeordnet sein. Bei den chemischen Sensorelementen 13 werden vorzugsweise passive, flache elektronische Bauteile verwendet, wie Widerstände, Spulen oder Kondensatoren oder andere, die auf Einwirkungen z. B. von Sauerstoff oder CO₂ oder andere chemische Stoffe ihre elektrischen Eigenschaften ändern. Ebenfalls können auch auf zumindest einer Seite der Basisplatte 2 physikalische Sensoren 5 angeordnet sein, die in Kombination mit der zweiten Platte 3 gebildet werden. Eine mechanische Einwirkung F, P auf die zweite Platte 3 hat eine Änderung einer elektrischen Grösse des physikalischen Sensors 5 zur Folge.

Der Leiterplattensensor 1 wird vorzugsweise in Grossserienanlagen hergestellt, indem eine Vielzahl von Sensoren 1, beispielsweise 300 bis 1000 Sensoren 1, auf einer gemeinsamen Basisplatte 2 und/oder einer gemeinsamen zweiten Platte 3 hergestellt werden. Figur 3 zeigt eine Draufsicht auf eine Mehrzahl noch nicht getrennter Sensoren 1, welche in einem nachfolgenden Verfahrensschritt entlang der Bruchlinien 1a,1b getrennt werden, beispielsweise durch Schlitzen oder Fräsen. Die Sensoren 1 können, falls erforderlich, zudem mit elektronischen Bauteilen bestückt werden, bevor diese voneinander getrennt werden. Somit können eine Vielzahl von Sensoren 1 gleichzeitig auf einer gemeinsamen Platte und zudem sehr kostengünstig gefertigt werden. Nach der Fertigstellung können die einzelnen Sensoren 1 vorzugsweise durch automatische Trennverfahren voneinander getrennt werden.

Der Leiterplattensensor 1 zum Messen von physikalischen Grössen wird vorzugsweise derart hergestellt, dass eine Basisplatte 2 aus Glas auf der ersten Seite 2a mit Leiterbahnen 4 versehen wird und auf der zweiten Seite 2b zumindest mit einer ersten metallischen oder polymerischen Oberfläche 5a versehen wird, wobei die erste metallische oder polymerische Oberfläche 5a über zumindest eine Durchkontaktierung 9 zumindest mit einer Leiterbahn 4 verbunden wird, und wobei eine zweite Platte 3 aus Glas auf der ersten Seite 3a zumindest mit einer zweiten metallischen oder polymerischen Oberfläche 5b versehen wird, und wobei die Basisplatte 2 sowie die zweite Platte 3 derart mit Hilfe von Abstandelementen 7 und/oder Leiterbahnen 6 miteinander verbunden werden, dass die erste metallische oder polymerische Oberfläche 5a der Basisplatte 2 sowie die zweite metallische oder polymerische Oberfläche 5b der zweiten Platte 3 gegenseitig insbesondere parallel und gegenseitig beabstandet verlaufen. Vorzugsweise werden die Basisplatte 2 sowie die zweite Platte 3 gegenseitig deckungsgleich ausgestaltet und angeordnet.

Vorzugsweise werden auf einer gemeinsamen Basisplatte 2 sowie einer gemeinsamen zweiten Platte 3 in Schichttechnik eine Vielzahl von Leiterplattensensoren 1 hergestellt, wobei die Leiterplattensensoren 1 nach deren Herstellung voneinander getrennt werden.

Vorteilhafterweise werden die Basisplatte 2 und die zweiten Platte 3 jedes Leiterplattensensors 1 derart gegenseitig über Abstandelemente 7 und/oder Leiterbahnen 6 verbunden, dass an der Aussenkante 1c des Leiterplattensensor 1 zwischen der Basisplatte 2 und der zweiten Platte 3 ein Spalt 8 erzeugt wird.

In einer weiteren vorteilhaften Ausgestaltung kann die Oberfläche 3b der zweiten Platte 3 wie in Figur 2 beispielhaft entlang eines kurzen Abschnittes dargestellt, eine Oberflächenstruktur 14 aufweisen, welche beispielsweise als mit Wölbungen oder Rillen versehene Oberfläche ausgestaltet ist. Diese Struktur 14 kann beispielsweise durch eine mechanische Bearbeitung erzeugt werden, beispielsweise mit Fräsen. Eine derartige Struktur 14 kann sich beispielsweise als vorteilhaft erweisen, wenn mit dem Leiterplattensensor 1 der Druck eines Fluides gemessen wird, wobei das Fluid derart geleitet ist, dass dieses entlang der mit einer Struktur 14 versehenen Seite 3b fliesst. Es könnten auch andere oder weitere Seiten 2a,2b,3a,3b der zweiten Platte 3 oder der Basisplatte 2 mit einer Oberflächenstruktur 14 versehen sein.

## Patentansprüche

1. Leiterplattensensor (1) zum Messen von physikalischen Grössen, umfassend eine Basisplatte (2) sowie eine zweite Platte (3) welche beide aus Glas bestehen, wobei zumindest die zweite Platte (3) derart ausgestaltet ist, dass diese elastisch verformbar ist, wobei die Basisplatte (2) sowie die zweite Platte (3) je eine erste und eine zweite Seite (2a,2b,3a,3b) aufweisen, wobei die zweite Seite (2b) der Basisplatte (2) sowie die erste Seite (3a) der zweiten Platte (3) gegenüberliegend angeordnet sind und wobei zwischen der Basisplatte (2) und der zweiten Platte (3) ein Abstandelement (7) angeordnet ist, welches die Basisplatte (2) sowie die zweite Platte (3) in einer gegenseitigen Distanz hält, wobei die Basisplatte (2) und die zweite Platte (3) insbesondere gegenseitig parallel verlaufen, **dadurch gekennzeichnet daß** die zweite Seite (2b) der Basisplatte (2) eine erste metallische oder polymerische Oberfläche (5a) und die erste Seite (3a) der zweiten Platte (3) eine zweite metallische oder polymerische Oberfläche (5b) aufweist, und wobei die erste und zweite metallische oder polymerische Oberfläche (5a,5b) zumindest teilweise gegenüberliegend angeordnet sind, und wobei auf der ersten Seite der Basisplatte (2) Leiterbahnen (4) aufgebracht sind, und wobei die Basisplatte (2) zumindest eine erste und eine zweite Durchkontaktierung (9) aufweist, welche derart angeordnet sind, dass die erste Durchkontaktierung (9a) die Leiterbahn (4) elektrisch leitend mit der ersten metallischen oder polymerische Oberfläche (5a) verbindet, und dass die zweite Durchkontaktierung (9b) die Leiterbahn (4) elektrisch leitend mit der zweiten metallischen oder polymerischen Oberfläche (5b) verbindet.

2. Leiterplattensensor nach Anspruch 1, **dadurch gekennzeichnet, dass** die Durchkontaktierungen (9) durch das Glas der Basisplatte (2) verlaufen, wobei die Durchkontaktierung (9) insbesondere bündig mit der ersten und zweiten Seite (2a,2b) der Basisplatte (2) ist.

3. Leiterplattensensor nach Anspruch 1, **dadurch gekennzeichnet, dass** die Durchkontaktierungen (9) an der Oberfläche entlang des Glases der Basisplatte (2) verlaufen.

4. Leiterplattensensor nach einem der vorhergehenden Ansprüche, **dadurch gekennzeichnet, dass** die Leiterbahnen (4,6,7) derart verlaufend angeordnet sind, dass eine elektronische Schaltung damit verbunden werden kann.

5. Leiterplattensensor nach einem der vorhergehenden Ansprüche, **dadurch gekennzeichnet, dass** die erste und zweite metallische oder polymerische Oberfläche (5a,5b) eine Kapazität und/oder eine Induktivität ausbilden.

6. Leiterplattensensor nach einem der vorhergehenden Ansprüche, **dadurch gekennzeichnet, dass** das Abstandelement (7) als Leiterbahn (6) ausgestaltet ist.

7. Leiterplattensensor nach Anspruch 6, **dadurch gekennzeichnet, dass** das Abstandelement (7) und /oder die Leiterbahn (6) derart angeordnet sind, dass sich zwischen der Basisplatte (2) und der zweiten Platte (3) an der Aussenkante (1c) ein Spalt (8) ausbildet.

8. Leiterplattensensor nach Anspruch 6 oder 7, **dadurch gekennzeichnet, dass** das Abstandelement (7) und/oder die Leiterbahn (6) die Basisplatte (2) sowie die zweite Platte (3) derart umschliesst, dass zwischen der Basisplatte (2) und der zweiten Platte (3) ein umschlossener Innenraum (12) gebildet ist.

9. Leiterplattensensor nach Anspruch 8, **dadurch gekennzeichnet, dass** die Basisplatte (2) einen fluiddurchlässigen Durchgang (11) aufweist, welcher von der ersten Seite (2a) bis zum Innenraum (12) verläuft.

10. Leiterplattensensor nach einem der vorhergehenden Ansprüche, **dadurch gekennzeichnet, dass** die Basisplatte (2) und die zweite Platte (3) deckungsgleich ausgestaltet sind.

11. Leiterplattensensor nach einem der vorhergehenden. Ansprüche, **dadurch gekennzeichnet, dass** die Basisplatte (2) und/oder die zweite Platte (3) Ausnehmungen, Bohrungen (11), Aussenkanten (1c) oder Bruchlinien (1a,1b) aufweist, welche insbesondere durch eine mechanische Bearbeitung wie Schlitzen, Bohrungen oder Fräsen erzeugt sind.

12. Leiterplattensensor nach einem der vorhergehenden Ansprüche, **dadurch gekennzeichnet, dass** zumindest ein zweiter Sensor (13) an oder oberhalb der zweiten Seite (3b) der zweiten Platte (3) angeordnet ist, wobei dieser Sensor (13) über elektrische Leiter (10) Signal leitend mit Leiterbahnen (4) verbunden ist, welche an der ersten Seite (2a) der Basisplatte (2) angeordnet sind, wobei der Sensor (13) insbesondere als ein chemischer Sensor ausgestaltet ist.

13. Verfahren zum Herstellen eines Leiterplattensensors (1) zum Messen von physikalischen Grössen, indem eine Basisplatte (2) aus Glas auf der ersten Seite (2a) mit Leiterbahnen (4) versehen wird und auf der zweiten Seite (2b) zumindest mit einer ersten metallischen oder polymerische Oberfläche (5a) versehen wird, und wobei die erste metallische oder polymerische Oberfläche (5a) über zumindest eine Durchkontaktierung (9) zumindest mit einer Leiterbahn (4) verbunden ist, und wobei eine zweite Platte (3) aus Glas auf der ersten Seite (3a) zumindest mit einer zweiten metallischen oder polymerische Oberfläche (5b) versehen wird, und wobei die Basisplatte (2) sowie die zweite Platte (3) derart mit Hilfe von Abstandelementen (7) und/oder Leiterbahnen (6) miteinander verbunden werden, dass die erste metallische oder polymerische Oberfläche (5a) der Basisplatte (2) sowie die zweite metallische oder polymerische Oberfläche (5b) der zweiten Platte (3) gegenseitig insbesondere parallel und gegenseitig beabstandet verlaufen, wobei die Basisplatte (2) sowie die zweite Platte (3) deckungsgleich ausgestaltet sind.

14. Verfahren nach Anspruch 13, **dadurch gekennzeichnet, dass** auf einer gemeinsamen Basisplatte (2) sowie einer gemeinsamen zweiten Platte (3) in Schichttechnik eine Vielzahl von Leiterplattensensoren (1) hergestellt wird; und dass die Leiterplattensensoren (1) nach deren Herstellung voneinander getrennt werden.

15. Verfahren nach Anspruch 13, **dadurch gekennzeichnet, dass** die Basisplatte (2) und die zweiten Platte (3) jedes Leiterplattensensors (1) derart gegenseitig über Abstandelemente (7) und/oder Leiterbahnen (6) verbunden werden, dass an der Aussenkante (1c) des Leiterplattensensor (1) zwischen der Basisplatte (2) und der zweiten Platte (3) ein Spalt (8) erzeugt wird.

## Claims

1. A circuit board sensor (1) for measuring physical parameters, comprising a base plate (2) as well as a second plate (3) which are both composed of glass, wherein at least the second plate (3) is designed such that this is elastically deformable, wherein the base plate (2) as well as the second plate (3) each have a side and a second side (2a, 2b, 3a, 3b), wherein the second side (2b) of the base plate (2) as well as the first side (3a) of the second plate (3) are arranged opposite to one another and wherein a spacer element (7) is arranged between the base plate (2) and the second plate (3) which maintains the base plate (2) as well as the second plate (3) at a mutual spacing, wherein the base plate (2) and the second plate (3) are in particular mutually parallel, **characterized in that** the second side (2b) of the base plate (2) has a first metallic or polymeric surface (5a) and the first side (3a) of the second plate (3) has a second metallic or polymeric surface (5b), and wherein the first and second metallic or polymeric surface (5a, 5b) are at least partially arranged opposite one another, and wherein conductive paths (4) are provided at the first side (2a) of the base plate (2), and wherein the base plate (2) has at least a first and second through contact (9) which are arranged such that the first through contact (9a) electrically conductively connects the conductive path (4) to the first metallic or polymeric surface (5a), and such that the second through contact (9b) electrically conductively connects the conductive path (4) to the second metallic or polymeric surface (5b).

2. A circuit board sensor in accordance with claim 1, **characterized in that** the trough contacts (9) run through the glass of the base plate (2), wherein the through contact (9) is in particular flush with the first and second side (2a, 2b) of the base plate (2).

3. A circuit board sensor in accordance with claim 1, **characterized in that** the through contacts (9) extend along the surface of the glass of the base plate (2).

4. A circuit board sensor in accordance with any one of the preceding claims, **characterized in that** the conductive paths (4/6/7) are arranged extending such that an electric circuit can be connected thereto.

5. A circuit board sensor in accordance with any one of the preceding claims, **characterized in that** the first and second metallic or polymeric surface (5a, 5b) form a capacitance and/or an inductance.

6. A circuit board sensor in accordance with any one of the preceding claims, **characterized in that** the spacer element (7) is designed as a conductive path (6).

7. A circuit board sensor in accordance with claim 6, **characterized in that** the spacer element (7) and/or the conductive path (6) are arranged such that a gap (8) forms at the outer edge (1c) between the base plate (2) and the second plate (3).

8. A circuit board sensor in accordance with claim 6 or claim 7, **characterized in that** the spacer element (7) and/or the conductive path (6) surround the base plate (2) as well as the second plate (3) such that an enclosed inner space (12) is formed between the base plate (2) and the second plate (3).

9. A circuit board sensor in accordance with claim 8, **characterized in that** the base plate (2) has a fluid permeable through passage (11) which extends from the first side (2a) to the inner space (12).

10. A circuit board sensor in accordance with any one of the preceding claims, **characterized in that** the base plate (2) and the second plate (3) are of identical design.

11. A circuit board sensor in accordance with any one of the preceding claims, **characterized in that** the base plate (2) and/or the second plate (3) has recesses, bores (11), outer edges (1c) or separation lines (1a, 1b) which are produced in particular by a mechanical machining such as slitting, drilling or milling.

12. A circuit board sensor in accordance with any one of the preceding claims, **characterized in that** at least a second sensor (13) is arranged at or above the second side (3b) of the second plate (3), wherein this sensor (13) is connected to the conductive paths (4) in a signal conducting manner via electric conductors (10) which conductive paths are arranged at the first side (2a) of the base plate (2), wherein the sensor (13) is in particular designed as a chemical sensor.

13. A method for the production of a circuit board sensor (1) for measuring physical parameters, in which a base plate (2) composed of glass is provided with conductive paths (4) at the first side (2a) and is provided with at least a first metallic or polymeric surface (5a) at the second side (2b) and wherein the first metallic or polymeric surface (5a) is connected to at least one conductive path (4) via at least one through contact (9), and wherein a second plate (3) composed of glass is provided with at least a second metallic or polymeric surface (5b) at the first side (3a) and wherein the base plate (2) as well as the second plate (3) are connected to one another with the aid of spacer elements (7) and/or conductive paths (6) such that the first metallic or polymeric surface (5a) of the base plate (2) as well as the second metallic or polymeric surface (5b) of the second plate (3) are arranged opposite one another, in particular are arranged in parallel to one another and mutually spaced apart, wherein the base plate (2) as well as the second plate (3) are designed congruent with one another.

14. A method in accordance with claim 13, **characterized in that** a plurality of circuit board sensors (1) are produced on a common base plate (2) as well as on a common second plate (3) in planigraphy, and **in that** the circuit board sensors (1) are separated from one another after their production.

15. A method in accordance with claim 13, **characterized in that** the base plate (2) and the second plate (3) of each circuit board sensor (1) are connected to one another via spacer elements (7) and/or conductive paths (6) such that a gap (8) is generated at the outer edge (1c) of the circuit board sensor (1) between the base plate (2) and the second plate (3).

## Revendications

1. Capteur à circuit imprimé (1) destiné à mesurer des grandeurs physiques, comprenant une plaque de base (2) ainsi qu'une deuxième plaque (3) qui sont toutes deux constituées de verre, au moins la deuxième plaque (3) étant configurée de telle sorte qu'elle peut subir une déformation élastique, la plaque de base (2) ainsi que la deuxième plaque (3) possédant respectivement un premier et un deuxième côté (2a, 2b, 3a, 3b), le deuxième côté (2b) de la plaque de base (2) et le premier côté (3a) de la deuxième plaque (3) étant disposés en opposition l'un à l'autre et un élément d'espacement (7) étant disposé entre la plaque de base (2) et la deuxième plaque (3), lequel maintient la plaque de base (2) ainsi que la deuxième plaque (3) à une distance mutuelle, la plaque de base (2) et la deuxième plaque (3) s'étendant notamment en parallèle l'une de l'autre, **caractérisé en ce que** le deuxième côté (2b) de la plaque de base (2) possède une première surface (5a) métallique ou polymérique et le premier côté (3a) de la deuxième plaque (3) une deuxième surface (5b) métallique ou polymérique, les première et deuxième surfaces (5a, 5b) métalliques ou polymériques étant disposées au moins partiellement en opposition l'une à l'autre et des pistes conductrices (4) étant appliquées sur le premier côté de la plaque de base (2), et la plaque de base (2) possédant au moins un premier et un deuxième contact traversant (9), lesquels sont disposés de telle sorte que le premier contact traversant (9a) relie électriquement la piste conductrice (4) à la première surface (5a) métallique ou polymérique, et que le deuxième contact traversant (9b) relie électriquement la piste conductrice (4) à la deuxième surface (5b) métallique ou polymérique.

2. Capteur à circuit imprimé selon la revendication 1, **caractérisé en ce que** les contacts traversants (9) s'étendent à travers le verre de la plaque de base (2), le contact traversant (9) étant notamment à fleur du premier et du deuxième côté (2a, 2b) de la plaque de base (2).

3. Capteur à circuit imprimé selon la revendication 1, **caractérisé en ce que** les contacts traversants (9) s'étendent sur la surface le long du verre de la plaque de base (2).

4. Capteur à circuit imprimé selon l'une des revendications précédentes, **caractérisé en ce que** les pistes conductrices (4, 6, 7) sont disposées en s'étendant de telle sorte qu'il est possible de relier un circuit électronique avec celles-ci.

5. Capteur à circuit imprimé selon l'une des revendications précédentes, **caractérisé en ce que** les première et deuxième surfaces (5a, 5b) métalliques ou polymériques forment une capacité et/ou une inductance.

6. Capteur à circuit imprimé selon l'une des revendications précédentes, **caractérisé en ce que** l'élément d'espacement (7) est réalisé sous la forme d'une piste conductrice (6).

7. Capteur à circuit imprimé selon la revendication 6, **caractérisé en ce que** l'élément d'espacement (7) et/ou la piste conductrice (6) sont disposés de telle sorte qu'il se forme un interstice (8) au niveau du bord extérieur (1c) entre la plaque de base (2) et la deuxième plaque (3).

8. Capteur à circuit imprimé selon la revendication 6 ou 7, **caractérisé en ce que** l'élément d'espacement (7) et/ou la piste conductrice (6) entourent la plaque de base (2) ainsi que la deuxième plaque (3) de telle sorte qu'un espace intérieur clos (12) est formé entre la plaque de base (2) et la deuxième plaque (3).

9. Capteur à circuit imprimé selon la revendication 8, **caractérisé en ce que** la plaque de base (2) possède une traversée perméable aux fluides (11) qui s'étend du premier côté (2a) jusqu'à l'espace intérieur (12).

10. Capteur à circuit imprimé selon l'une des revendications précédentes, **caractérisé en ce que** la plaque de base (2) et la deuxième plaque (3) sont configurées en coïncidence.

11. Capteur à circuit imprimé selon l'une des revendications précédentes, **caractérisé en ce que** la plaque de base (2) et/ou la deuxième plaque (3) possèdent des évidements, des orifices (11), des bords extérieurs (1c) ou des lignes de rupture (1a, 1b), lesquels sont notamment produits par un usinage mécanique comme le rainurage, le perçage ou le fraisage.

12. Capteur à circuit imprimé selon l'une des revendications précédentes, **caractérisé en ce qu'**au moins un deuxième capteur (13) est disposé sur le deuxième côté (3b) de la deuxième plaque (3), ou au-dessus de celui-ci, ce capteur (13) étant relié en conduction de signal par le biais de conducteurs électriques (10) à des pistes conductrices (4) qui sont disposées sur le premier côté (2a) de la plaque de base (2), le capteur (13) étant notamment configuré sous la forme d'un capteur chimique.

13. Procédé de fabrication d'un capteur à circuit imprimé (1) destiné à mesurer des grandeurs physiques, en dotant une plaque de base (2) en verre de pistes conductrices (4) sur le premier côté (2a) et en la dotant d'au moins une première surface (5a) métallique ou polymérique sur le deuxième côté (2b), et la première surface (5a) métallique ou polymérique étant reliée à au moins une piste conductrice (4) par le biais d'au moins un contact traversant (9), et une deuxième plaque (3) en verre étant dotée d'au moins une deuxième surface (5b) métallique ou polymérique sur le premier côté (3a), et la plaque de base (2) ainsi que la deuxième plaque (3) étant reliées ensemble à l'aide d'éléments d'espacement (7) et/ou de pistes conductrices (6) de telle sorte que la première surface (5a) métallique ou polymérique de la plaque de base (2) ainsi que la deuxième surface (5b) métallique ou polymérique de la deuxième plaque (3) s'étendent en opposition, notamment en étant espacées mutuellement et parallèlement, la plaque de base (2) ainsi que la deuxième plaque (3) étant configurées en coïncidence.

14. Procédé selon la revendication 13, **caractérisé en ce qu'**une pluralité de capteurs à circuit imprimé (1) est fabriquée par technique d'empilage sur une plaque de base (2) commune ainsi qu'une deuxième plaque (3) commune, et **en ce que** les capteurs à circuit imprimé (1) sont séparés les uns des autres après leur fabrication.

15. Procédé selon la revendication 13, **caractérisé en ce que** la plaque de base (2) et la deuxième plaque (3) de chaque capteur à circuit imprimé (1) sont reliées en opposition l'une à l'autre par le biais d'éléments d'espacement (7) et/ou de pistes conductrices (6) de telle sorte qu'un interstice (8) est produit au niveau du bord extérieur (1c) du capteur à circuit imprimé (1) entre la plaque de base (2) et la deuxième plaque (3).
